(19) Europäisches Patentamt / European Patent Office / Office européen des brevets

(11) **EP 4 264 245 B1**

(12) **EUROPÄISCHE PATENTSCHRIFT**

(45) Veröffentlichungstag und Bekanntmachung des Hinweises auf die Patenterteilung:
**29.01.2025   Patentblatt 2025/05**

(21) Anmeldenummer: **21839330.4**

(22) Anmeldetag: **13.12.2021**

(51) Internationale Patentklassifikation (IPC):
*G01N 24/08* (2006.01)   *G01N 24/10* (2006.01)
*G01R 33/38* (2006.01)   *G01R 33/60* (2006.01)
*G01R 33/383* (2006.01)   *G01R 33/389* (2006.01)
*G07D 7/04* (2016.01)   *H01F 7/02* (2006.01)
*H01F 3/10* (2006.01)

(52) Gemeinsame Patentklassifikation (CPC):
**G01N 24/08; G01N 24/10; G01R 33/3806;
G01R 33/60; G07D 7/04; H01F 3/10;** G01R 33/383;
G01R 33/389; H01F 2003/103

(86) Internationale Anmeldenummer:
**PCT/EP2021/025494**

(87) Internationale Veröffentlichungsnummer:
**WO 2022/128153 (23.06.2022 Gazette 2022/25)**

(54) **SENSORELEMENT UND VORRICHTUNG FÜR DIE ECHTHEITSPRÜFUNG EINES DATENTRÄGERS MIT EINEM SPINRESONANZ-MERKMAL**

SENSOR ELEMENT AND DEVICE FOR AUTHENTICATING A DATA CARRIER HAVING A SPIN RESONANCE FEATURE

ÉLÉMENT CAPTEUR ET DISPOSITIF D'AUTHENTIFICATION DE SUPPORT DE DONNÉES À CARACTÉRISTIQUE DE RÉSONANCE DE SPIN

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.12.2020   DE 102020007707**

(43) Veröffentlichungstag der Anmeldung:
**25.10.2023   Patentblatt 2023/43**

(73) Patentinhaber: **Giesecke+Devrient Currency Technology GmbH
81677 München (DE)**

(72) Erfinder:
• **HUBER, Stephan
  80634 München (DE)**
• **SCHULLER, Christian
  84513 Erharting (DE)**

(74) Vertreter: **Giesecke+Devrient IP
Prinzregentenstraße 161
81677 München (DE)**

(56) Entgegenhaltungen:
EP-A1- 0 541 872    CN-A- 1 401 295
DE-A1- 3 408 086    DE-T5- 112016 000 211
JP-A- H0 739 537    SU-A1- 1 054 752
US-A- 5 149 946    US-A1- 2005 253 585

• ANONYMOUS: "ELECTRON SPIN RESONANCE (ESR)", 22 February 2020 (2020-02-22), Internet, pages 1 - 6, XP055901772, Retrieved from the Internet <URL:http://www.its.caltech.edu/~derose/labs/exp6.html> [retrieved on 20220316]
• ANONYMOUS: "Designing with Magnetic Cores at High Temperatures", 23 August 2016 (2016-08-23), XP055902148, Retrieved from the Internet <URL:https://web.archive.org/web/20160823192558/http://www.mag-inc.com/design/design-guides/designing-with-magnetic-cores-at-high-temperatures> [retrieved on 20220316]

• ANONYMOUS: "Electron Spin Resonance (ESR)", 22 February 2020 (2020-02-22), XP055901775, Retrieved from the Internet <URL:https://web.archive.org/web/20200222194518/www.its.caltech.edu/~derose/labs/exp6.html> [retrieved on 20220316]

• RIZWAN AHMAD ET AL: "Theory, Instrumentation, and Applications of Electron Paramagnetic Resonance Oximetry", CHEMICAL REVIEWS, vol. 110, no. 5, 12 May 2010 (2010-05-12), US, pages 3212 - 3236, XP055441105, ISSN: 0009-2665, DOI: 10.1021/cr900396q

**Beschreibung**

Die Erfindung betrifft ein Sensorelement für die Echtheitsprüfung eines flächigen Datenträgers, insbesondere einer Banknote, mit einem Spinresonanz-Merkmal, sowie eine Prüfvorrichtung mit einem solchen Sensorelement.

Datenträger, wie Wert- oder Ausweisdokumente, aber auch andere Wertgegenstände, wie etwa Markenartikel, werden zur Absicherung oft mit Sicherheitselementen versehen, die eine Überprüfung der Echtheit der Datenträger gestatten und die zugleich als Schutz vor unerlaubter Reproduktion dienen.

Um eine automatische Echtheitsprüfung und gegebenenfalls eine weitergehende sensorische Erfassung und Bearbeitung der damit versehenen Datenträger zu ermöglichen, sind die Sicherheitselemente oft maschinenlesbar ausgebildet. Für diesen Zweck werden beispielsweise seit langem Sicherheitselemente mit magnetischen Bereichen eingesetzt, deren Informationsgehalt bei der Echtheitsprüfung von dem Magnetsensor eines Banknotenbearbeitungssystems maschinell erfasst und ausgewertet werden kann.

Bei der maschinellen Echtheitsprüfung ist es auch bekannt, Sicherheitselemente mit Spinresonanz-Merkmalen zur Absicherung von Dokumenten und anderen Datenträgern einzusetzen.

Spinresonanz-Merkmale beruhen allgemein auf einer resonanten Energieabsorption eines Spin-Ensembles in einem äußeren Magnetfeld. Physikalisch liegt der resonanten Energieabsorption die Aufspaltung der Energiezustände des Spin-Ensembles im äußeren Magnetfeld zugrunde. Spins, deren magnetische Momente parallel zu dem äußeren Feld orientiert sind, haben einen niedrigeren Energiezustand als Spins mit einem antiparallelen magnetischen Moment. Durch das Einstrahlen eines magnetischen Wechselfeldes passender Stärke, das senkrecht zu dem als Polarisationsfeld bezeichneten, äußeren Magnetfeld orientiert ist, können resonant Übergänge zwischen den Energieniveaus angeregt werden.

Die zur Anregung der Übergange notwendige Resonanzfrequenz $\omega_L$ ist durch die Energiedifferenz der aufgespaltenen Niveaus gegeben,

$$\omega_L = \gamma \, B_c$$

wobei $\gamma$ das gyromagnetische Verhältnis der beteiligten Spins angibt, und Bc das relevante charakteristische Magnetfeld bezeichnet. Die charakteristische Resonanzfrequenz eines Spin-Ensembles kann auch als Larmor-Frequenz bezeichnet werden.

Zur Echtheitsabsicherung können in Sicherheitselementen als Spin-Ensembles sowohl Kernspins als auch Elektronspins genutzt werden, entsprechend spricht man bei der resonanten Anregung von Kernspin-Resonanz (Nuclear Magnetic Resonance, NMR) oder von Elektronspin-Resonanz (ESR). Auch Materialien mit hoher Elektronenspindichte, bei denen die Wechselwirkung der Spins untereinander nicht mehr zu vernachlässigen ist, können eingesetzt werden. Hierzu zählen ferro- und ferrimagnetische Materialien, und man spricht in diesen Fällen allgemein von ferromagnetischer Resonanz (FMR).

Bei der NMR und ESR ist das relevante charakteristische Magnetfeld $B_c$ im Wesentlichen durch das äußere Magnetfeld $B_0$ gegeben, bei der FMR hängt die Resonanzbedingung auch von im Material vorliegenden inneren Feldern ab, die zusammen mit dem äußeren Magnetfeld ein effektives Feld $B_{eff}$ bilden, das dann das für die Berechnung der Resonanzfrequenz relevante charakteristische Magnetfeld $B_c$ darstellt.

Bei üblichen Magnetfeldstärken liegt bei der NMR die Resonanzfrequenz typischerweise im MHz-Bereich, bei der ESR und FMR typischerweise deutlich höher im GHz-Bereich.

US 5 149 946 A offenbart ein Verfahren zur Authentifizierung eines Objekts mittels paramagnetischer Elektronenresonanzspektroskopie, wobei das Verfahren dadurch gekennzeichnet ist, dass dem Objekt mindestens eine authentifizierende Substanz zugesetzt wird, wobei die Substanz einen EPR-Peak aufweist, dessen Breite nicht größer als etwa 1,5 Gauss ist, wobei die Spektroskopie in einem statischen Feld mit einer solchen Amplitude durchgeführt wird, dass die Substanz eine Resonanzfrequenz im Hochfrequenzbereich aufweist. Die Breite des EPR-Peaks der Substanz wird als Unterscheidungskriterium verwendet. Dem statischen Feld ist vorzugsweise ein niederfrequentes kollineares Modulationsfeld überlagert, das eine Amplitude aufweist, die wesentlich größer ist als die EPR-Breite der Substanz, und unter einem hochfrequenten elektromagnetischen Feld, das sich senkrecht zum statischen Feld und zum Modulationsfeld erstreckt und eine Amplitude aufweist nicht kleiner als die Peakbreite ist, wodurch paramagnetische Materialien mit einer Peakbreite, die größer als die der Authentifizierungssubstanz ist, nicht erkannt werden. Es wird auch eine Vorrichtung zur Durchführung des Verfahrens und ein mit dem Verfahren verwendbares Sicherheitspapier beschrieben. Die Vorrichtung enthält vorzugsweise Ferritkerne, welche zwischen sich einen Spalt für das Objekt ausbilden.

SU 1 054 752 A1 offenbart eine Quelle für ein polarisierendes Magnetfeld für spektroskopische Geräte. Sie verfügt über einen Permanentmagneten mit einem Mechanismus zur Einstellung des Magnetfeldes, eine Magnetfeldsteuereinrichtung und einen Magnetfeldsensor, der in dem Arbeitsspalt des Magneten angeordnet ist. Um die Stabilität des Magnetfeldes und die Linearität einer Magnetfeldänderung zu verbessern, enthält sie weiter einen programmierbaren Pulsgenerator, Pulsmodulationsspulen, eine Sample-and-Hold-Schaltung, einen Fehlerverstärker und eine Schalteinheit. Dabei ist die Schalteinheit mittels des ersten Ausgangs zu den Pulsmodulationsspulen mit dem programmierbare Pulsgenerator, mittels des zweiten Ausgangs zu dem Gate-Eingang der Sample-and-Hold-Schaltung und mittels des dritten Ausgangs mit dem Schalteingang der Schalteinheit verbunden. Die Sample-and-Hold-Schaltung, der Fehlerverstärker und die Schalteinheit sind in Reihe geschaltet und mechanisch mittels eines Magnetfeldsensors verbunden, der zwischen den Pulsmodulationsspulen und der Magnetfeldsteuereinheit angeordnet ist. Der zweite Eingang des Fehlerverstärkers ist direkt mit dem Ausgang des Magnetfeldsensors gekoppelt.

Ausgehend davon liegt der Erfindung die Aufgabe zugrunde, eine Vorrichtung anzugeben, die eine zuverlässige Echtheitsprüfung von Datenträgern mit Spinresonanz-Merkmalen erlaubt, und die insbesondere auch die Prüfung schnell bewegter Datenträger erlaubt.

Diese Aufgabe wird durch die Merkmale der unabhängigen Ansprüche gelöst. Weiterbildungen der Erfindung sind Gegenstand der abhängigen Ansprüche.

Die Erfindung stellt ein Sensorelement für die Prüfung, insbesondere Echtheitsprüfung, eines flächigen Datenträgers mit einem Spinresonanz-Merkmal bereit. Bei dem Datenträger kann es sich beispielsweise um eine Banknote handeln. Das Sensorelement enthält einen Magnetkern mit einem Luftspalt, in den der flächige Datenträger zur Echtheitsprüfung einbringbar ist, ein Element zu Erzeugung eines statischen magnetischen Flusses in dem Luftspalt, eine Modulationsspule zur Erzeugung eines zeitlich variierenden Magnetfelds in dem Luftspalt, und einen Resonator zur Anregung des Spinresonanz-Merkmals des zu prüfenden Datenträgers und zur Erfassung der Signalantwort des Spinresonanz-Merkmals. Der Magnetkern des Sensorelements ist dabei zumindest teilweise aus einem wirbelstromdämpfenden Magnetmaterial gebildet.

Das wirbelstromdämpfende Magnetmaterial weist zumindest entlang einer Raumrichtung vorteilhaft eine mindestens 3-fach, vorzugsweise mindestens 5-fach, insbesondere mindestens 10-fach geringere elektrische Leitfähigkeit als Weicheisen-Vollmaterial auf.

In einer vorteilhaften Ausgestaltung umfasst der Magnetkern als wirbelstromdämpfendes Magnetmaterial ein Lamellenpaket aus einem weichmagnetischen Werkstoff, insbesondere auf Basis einer SiFe-Legierung, einer NiFe-Legierung, einer CoFe-Legierung, einer AlFe-Legierung oder einem metallischen Glas. Durch den geringen Querschnitt der Lamellen und die dazwischen liegenden Isolationsschichten wird die elektrische Leitfähigkeit des Ausgangsmaterials stark reduziert, während die vorteilhaften magnetischen Eigenschaften des weichmagnetischen Ausgangsmaterials erhalten bleiben.

Die elektrische Leitfähigkeit des Lamellenpakets ist dabei stark abhängig von der Stärke der Lamellen, wobei typische Lamellenstärken bei etwa 35 μm oder sogar darunter liegen. Die Leitfähigkeit eines Lamellenpakets ist darüber hinaus stark richtungsabhängig und senkrecht zur Lamellenebene besonders gering. Daher werden die Lamellen vorteilhaft so angeordnet, dass die Richtung des wirbelstrominduzierenden Magnetfelds, insbesondere des Modulationsfelds, in der Ebene der Lamellen liegt.

Ebenfalls mit Vorteil kann der Magnetkern als wirbelstromdämpfendes Magnetmaterial ein Ferrit umfassen. Die genannten Ferrite sind ferrimagnetische Werkstoffe, beispielsweise Werkstoffe auf MnZn-Basis oder auf NiZn-Basis, die durch eine Sinterung zu dem gewünschten Magnetkern oder Magnetkernteil geformt werden. Ferrite zeichnen sich durch eine hohe Permeabilität bei noch akzeptabler Sättigungsmagnetisierung aus und haben gleichzeitig eine sehr geringe elektrische Leitfähigkeit.

Der Magnetkern umfasst als wirbelstromdämpfendes Magnetmaterial ein weichmagnetisches Pulver, dessen Pulverpartikel zueinander elektrisch isoliert sind. Ausgangsstoff für solche Pulverkerne kann bspw. reines Eisen bzw. Carbonyleisen sein. Weitere Möglichkeiten sind etwa SiFe-, NiFe-, NiMoFe oder SiAlFe-Legierungen.

Die elektrische Isolation der Pulverpartikel kann bspw. dadurch erreicht werden, dass das Pulver in einem isolierenden Bindemittel dispergiert wird. Weiterhin kann eine elektrische Isolation durch eine Oxidschicht an der Pulveroberfläche bzw. eine weitere geeignete Beschichtung entstehen. Anschließend wird das Pulver zum gewünschten Magnetkern oder Magnetkernteil geformt.

Die vorteilhaften magnetischen Eigenschaften des Magnetkerns leiten sich dann aus dem weichmagnetischen Pulver ab, während die elektrische Leitfähigkeit durch die elektrische Isolation der einzelnen Pulverkörner gegenüber dem weichmagnetischen Vollmaterial stark abgesenkt wird. Weichmagnetisches Pulvermaterial zeichnet sich gegenüber Ferrit durch seine höhere Sättigungsmagnetisierung aus, wodurch es für den Einsatz bei hohen Magnetfeldstärken geeignet ist.

Weiter kann der Magnetkern als wirbelstromdämpfendes Magnetmaterial ein Paket aus parallel angeordneten weichmagnetischen Stäbchen umfassen, die zueinander elektrisch isoliert sind. Das Material der Stäbchen kann beispielsweise reines Eisen, Carbonyleisen oder eine SiFe-, NiFe-, NiMoFe oder SiAlFe-Legierung sein. Die elektrische Isolation kann beispielsweise durch eine Beschichtung der Stäbchen mit einem isolierenden Material oder durch eine Oxidschicht an der Oberfläche der Stäbchen erfolgen. Weiterhin ist es möglich, die Stäbchen mit einem elektrisch isolierenden Klebstoff zu verkleben. Der Durchmesser der Stäbchen beträgt vorteilhaft weniger als 2 mm, bevorzugt weniger als 0.5 mm.

Ähnlich wie ein Lamellenpaket weist ein Stäbchenpaket eine stark anisotrope elektrische Leitfähigkeit auf, wobei jedoch nur in einer Richtung, nämlich entlang der Stäbchenachse, die Eigenschaften des Vollmaterials weitgehend erhalten bleiben. In den beiden senkrecht dazu stehenden Richtungen ist die elektrische Leitfähigkeit stark reduziert. Daher werden die Stäbchen vorteilhaft so angeordnet, dass die Richtung des wirbelstrominduzierenden Magnetfelds, insbesondere des Modulationsfelds, parallel zur Stäbchenachse liegt.

Die nachfolgende Tabelle zeigt typische Werte für die maximale Permeabilität $\mu_{max}$ (Permeabilität des Materials kurz vor Erreichen der Sättigung), die Sättigungsmagnetisierung $B_S$ und die elektrische Leitfähigkeit $\sigma$ verschiedener, in der vorliegenden Anmeldung angesprochener Stoffe. Der Eintrag Weicheisen bezeichnet ein Weicheisen-Vollmaterial mit vorteilhaften magnetischen Eigenschaften aber hoher elektrischer Leitfähigkeit (Vergleichsmaterial).

|  | $B_S$ (T) | $\mu_{max}$ | $\sigma$ (S/m) |
|---|---|---|---|
| Weicheisen (Vergleichsmaterial) | 2,1 | 15.000 | $10^7$ |
| Elektroblech (Lamellenpaket) | 1,7 | 10.000 | $2 * 10^6$ |
| Ferrit | 0,3 | 200 | $1*10^{-6}$ |
| Pulver-Material | 1,2 | 20 | $1*10^{-5}$ |

Die Materialauswahl wird bei einem konkreten Aufbau eines Magnetkerns unter Berücksichtigung der gewünschten Baugröße des Kerns, der Verluste durch einen magnetischen Streufluss und der auftretenden Wirbelströme getroffen. Wie aus der Tabelle ersichtlich, werden Wirbelströme wegen ihrer äußerst geringen elektrischen Leitfähigkeit durch Ferrit- und Pulver-Materialien besonders effizient unterdrückt. Diese Materialien können daher in einem Magnetkern insbesondere in der Nähe des Luftspalts, wo die Wirbelströme besonders stark stören, zum Einsatz kommen.

Gleichzeitig weisen Ferrit- und Pulver-Materialien allerdings eine geringere Sättigungsflussdichte und eine geringere Permeabilität auf als lamellierte Materialien. Soll also in einer Anwendung ein nahezu statischer, hoher magnetischer Fluss möglichst verlustfrei geleitet werden, etwa im Verbindungsstück zwischen Permanentmagnet und Luftspalt, so bietet sich die Verwendung lamellierter Materialien in diesen Bereichen an, da diese aufgrund ihrer hohen Sättigungsflussdichte eine kompakte Bauform ermöglichen und aufgrund ihrer hohen Permeabilität magnetische Streuflüsse effizient unterdrücken.

In einer vorteilhaften Ausgestaltung umfasst der Magnetkern neben dem zumindest einen wirbelstromdämpfenden Magnetmaterial auch ein Vollmaterial hoher Permeabilität und hoher Sättigungsflussdichte, insbesondere Weicheisen. Auf diese Weise kombiniert man die vorteilhaften Eigenschaften beider Materialien und erreicht einen besonders geringen magnetischen Widerstand des gesamten magnetischen Kreises.

Mit Vorteil ist der Magnetkern zumindest in einem, bevorzugt in beiden an den Luftspalt angrenzenden Bereichen durch ein wirbelstromdämpfendes Magnetmaterial gebildet. Dies ist vorteilhaft, da in diesen Bereichen besonders hohe Wirbelströme auftreten.

Es können vorteilhaft auch mehrere verschiedene wirbelstromdämpfende Magnetmaterialien in einem Magnetkern eingesetzt werden. Beispielsweise können die an den Luftspalt angrenzenden Bereiche durch ein oben genanntes Ferrit-Magnetmaterial oder Pulver-Magnetmaterial gebildet sein, das eine besonders niedrige elektrische Leitfähigkeit aufweist, während weitere Bereiche des Magnetkerns durch ein genanntes Lamellenpaket gebildet sind, das trotz seiner wirbelstromdämpfenden Eigenschaften noch eine hohe Permeabilität und eine hohe Sättigungsflussdichte aufweist. Die weiteren Bereiche können auch den gesamten Rest des Magnetkerns bilden, so dass der gesamte Magnetkern aus wirbelstromdämpfenden Magnetmaterialien gebildet ist.

In einer vorzugsweisen Ausgestaltung ist die Modulationsspule im Luftspalt des Magnetkerns angeordnet. So werden nur vergleichsweise geringe Wirbelströme im Magnetkern induziert. In einer anderen, ebenfalls vorzugsweisen Ausgestaltung ist die Modulationsspule um einen Bereich mit wirbelstromdämpfendem Magnetmaterial, insbesondere um einen Bereich mit dem genannten Ferrit-Magnetmaterial oder Pulver-Magnetmaterial gewickelt. Dies ermöglicht eine geringere Spaltbreite und damit ein höheres statisches Magnetfeld im Spalt.

Das Element zu Erzeugung eines statischen magnetischen Flusses ist vorteilhaft durch zumindest einen Permanentmagneten gebildet. Dies reduziert gegenüber einem Aufbau, bei dem auch der statische Anteil des magnetischen Flusses durch einen Elektromagneten erzeugt wird, den Energieverbrauch und die Abwärme. Es kann in anderen Gestaltungen, die nicht unter den Schutzumfang der Ansprüche fallen, allerdings auch vorteilhaft sein, nicht nur den zeitveränderlichen Anteil, sondern auch den statischen Anteil des magnetischen Flusses im Luftspalt mittels Elektromagneten zu erzeugen. Dies ermöglicht nach dem Abschalten des Sensorelements eine besonders einfache Handhabung, insbesondere bei Aufbau, Zerlegung und Transport der Prüfvorrichtung.

Insbesondere ist es vorgesehen, dass das Element zu Erzeugung des statischen magnetischen Flusses aus mehreren Permanentmagneten ausgebildet ist. Dadurch kann eine höhere Flussdichte im Luftspalt erreicht werden.

Auch für einen Permanentmagneten ist es vorteilhaft, diesen mit einem Magnetkern aus nicht permanent magnetisiertem Material zu kombinieren. Dies ermöglicht eine höhere Designfreiheit in der Bauform, eine leichtere Herstellbarkeit und eine höhere mechanische Robustheit des Aufbaus.

Der Resonator ist mit Vorteil im Luftspalt des Magnetkerns angeordnet. Vorteilhaft kommt dabei ein Oberflächen-Resonator zum Einsatz. Dies ermöglicht eine geringe Baugröße und eine gut auf die flächige Probe angepasste Geometrie des Magnetfelds.

Das Sensorelement weist mit Vorteil weiter eine Rampspule zur Erzeugung eines gegenüber dem Modulationsfeld langsam zeitlich variierenden Magnetfelds in dem Luftspalt auf. Die Rampspule ist vorzugsweise um den Magnetkern, insbesondere einen wirbelstromdämpfenden Bereich des Magnetkerns, gewickelt. Die Rampspule dient insbesondere der Erzeugung einer Rampenfunktion des Polarisationsfelds und/oder der Kompensation eventueller Drifts der Stärke des Polarisationsfelds.

Die genannte Modulationsspule ist vorzugsweise auf die Erzeugung eines mit einer Frequenz zwischen etwa 1 kHz und etwa 1 MHz variierenden Magnetfelds in dem Luftspalt ausgelegt. Die genannte Rampspule ist vorzugsweise auf die Erzeugung eines mit einer Frequenz unterhalb von etwa 1 kHz variierenden Magnetfelds in dem Luftspalt ausgelegt. Der Resonator ist vorzugsweise auf die Anregung und Erfassung von Spinresonanz-Signalen mit einer Frequenz zwischen etwa 1 MHz und 100 GHz ausgelegt.

Bei dem Spinresonanz-Merkmal des zu prüfenden Datenträgers handelt es sich insbesondere um ein Kernspin-Resonanz-Merkmal, ein Elektronspin-Resonanz-Merkmal oder ein ferromagnetisches Resonanzmerkmal in einem ferro- oder ferrimagnetischen Stoff.

Das Sensorelement umfasst eine Auswerteeinheit. Die Auswerteeinheit ist insbesondere dazu eingerichtet, anhand der von dem Resonator erfassten Signalantwort des Spinresonanz-Merkmals ein Prüfergebnis zu erzeugen. Dazu wird bevorzugt eine aus der Signalantwort abgeleitete charakteristische Eigenschaft mit einem Referenzwert oder einem Referenzintervall verglichen, und bei ausreichend hoher Übereinstimmung ein positives Prüfergebnis ausgegeben, das zum Beispiel die Echtheit oder eine Klassenzugehörigkeit des geprüften Wertdokuments anzeigt. Als charakteristische Eigenschaften können beispielsweise die Resonanzfrequenz der Spinresonanz, deren Linienbreite oder Amplitude, eine Relaxationszeit der Spinresonanz oder die räumliche Verteilung des Spinresonanz-Merkmals herangezogen werden.

Die Erfindung umfasst weiter eine Prüfvorrichtung für die Echtheitsprüfung flächiger Datenträger, insbesondere von Banknoten, mit einem Sensorelement der beschriebenen Art und mit einer Transporteinrichtung, die die zu prüfenden flächigen Datenträger entlang eines Transportpfades in den Luftspalt des Magnetkerns einbringt bzw. durch den Luftspalt des Magnetkerns hindurchführt.

Die Prüfvorrichtung kann insbesondere Teil einer Banknotenbearbeitungsmaschine sein.

Die Erfindung betrifft auch eine Verwendung eines erfindungsgemäßen Sensorelements. Das Sensorelement wird zur Echtheitsprüfung eines flächigen Datenträgers mit Spinresonanz-Merkmal verwendet. Insbesondere wird die Echtheitsprüfung mit einem gepulsten Messverfahren, einem Dauerstrich (cw)-Messverfahren, einem Rapid Scan-Messverfahren und/oder einem Messverfahren mit statischem Magnetfeld $B_0$ durchgeführt.

Weitere Ausführungsbeispiele sowie Vorteile der Erfindung werden nachfolgend anhand der Figuren erläutert, bei deren Darstellung auf eine maßstabs- und proportionsgetreue Wiedergabe verzichtet wurde, um die Anschaulichkeit zu erhöhen.

Es zeigen:

Fig. 1 schematisch eine Prüfvorrichtung mit einem zugeführten Banknotenprüfling,

Fig. 2 das Sensorelement der Prüfvorrichtung der Fig. 1 in einer konkreten Ausführungsform genauer,

Fig. 3 die relative Signalintensität in Abhängigkeit von der Modulationsfrequenz für zwei verschiedene Flussleitstücke in einem Magnetkern,

Fig. 4 ein Sensorelement nach einem anderen Ausführungsbeispiel der Erfindung, und

Fig. 5 ein Sensorelement nach einem weiteren Ausführungsbeispiel der Erfindung.

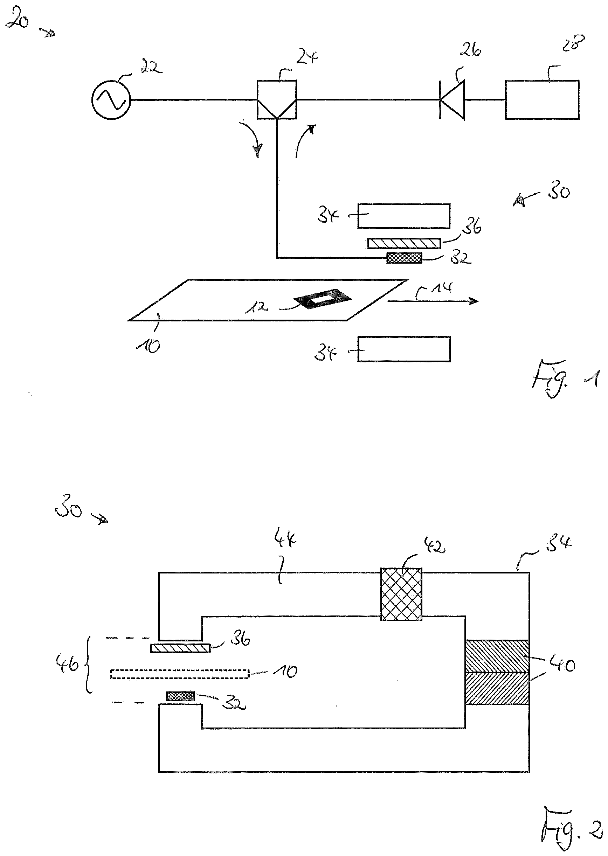

Die Erfindung wird nun am Beispiel der Echtheitsprüfung einer Banknote 10 erläutert. Figur 1 zeigt dazu schematisch eine Prüfvorrichtung 20 mit einem zugeführten Banknotenprüfling 10 und Fig. 2 zeigt das Sensorelement 30 der Prüfvorrichtung in einer konkreten Ausführungsform genauer.

Mit Bezug zunächst auf Fig. 1 wird in einem Dauerstrich-Messverfahren ein Banknotenprüfling 10 zur Echtheitsprüfung entlang eines Transportpfads 14 durch die Prüfvorrichtung 20 geführt. Der Banknotenprüfling 10 weist in einem Merkmalsbereich ein zu prüfendes Spinresonanz-Merkmal 12 auf, dessen charakteristische Eigenschaften zum Nachweis der Echtheit der Banknote dienen. Als charakteristische Eigenschaften können beispielsweise die Resonanzfrequenz der Spinresonanz, deren Linienbreite oder Amplitude, eine Relaxationszeit der Spinresonanz oder die räumliche Verteilung des Spinresonanz-Merkmals herangezogen werden.

Die Prüfvorrichtung 20 enthält eine Signalquelle 22, die im Ausführungsbeispiel im Dauerstrich (CW) bei einer festen Anregungsfrequenz $\omega_L$ betrieben wird, die der erwarteten Larmor-Frequenz des Spinresonanz-Merkmals 12 entspricht. Das Anregungssignal der Signalquelle 22 wird über einen Duplexer 24 einem abgestimmten Resonator 32 des Sensorelements 30 zugeführt und erzeugt dort ein magnetisches Wechselfeld der Frequenz $\omega_L$. Der Resonator 32 befindet sich im Feld eines Polarisationsmagneten 34, dessen Feldstärke mit einer langsamen Rampe ($f_{sweep}$ < 1 kHz) zeitlich variiert wird. Das Antwortsignal des Spinresonanz-Merkmals 12 wird vom Resonator 32 aufgenommen und über den Duplexer 24 zu einem Detektor 26 und einer Auswerteeinheit 28 geführt.

Erfüllt nun das zeitlich variierende Polarisationsfeld in Verbindung mit der festen Anregungsfrequenz die oben genannte Resonanzbedingung $\omega_L = \gamma B_c$, so werden im Spinresonanz-Merkmal 12 Übergänge zwischen den Spinzuständen angeregt. Dies führt zu einer Absorption des magnetischen Wechselfelds im Resonator und damit zu einer verringerten Resonatorgüte, die sich als Pegeländerung in dem vom Detektor 26 erfassten Antwortsignal zeigt.

Um die Sensitivität der Prüfvorrichtung 20 zu steigern und insbesondere das das Signal-zu-Rausch-Verhältnis dominierende 1/f-Rauschen zu unterdrücken, enthält das Sensorelement 30 weiter eine Modulationsspule 36, die das Polarisationsfeld des Magneten 34 und damit auch die Resonanzbedingung mittels eines zu dem Polarisationsfeld parallelen Modulationsfelds $B_{mod}$ moduliert. Die Modulationsfrequenz $f_{mod}$ des Modulationsfelds liegt dabei üblicherweise im Bereich zwischen etwa 1 kHz und etwa 1 MHz und erlaubt eine rauscharme Messung des modulierten Detektorsignals mittels Lock-In-Techniken.

In Fig. 2 ist schematisch das Sensorelement 30 der Fig. 1 in einer konkreten Ausführungsform genauer dargestellt. Die Position des Banknotenprüflings 10 ist gestrichelt angedeutet, wobei der Transportpfad 14 des Banknotenprüflings in der Figur senkrecht zur Bildebene verläuft.

Das Sensorelement 30 umfasst einen Polarisationsmagneten 34 mit Magnetrückschluss mit einem Permanentmagneten 40, einer Rampspule 42 und einem Magnetkern 44 mit Luftspalt 46. Der Magnetkern 44 leitet den magnetischen Fluss des Permanentmagneten 40 und der um den Magnetkern gewickelten Rampspule 42 zu dem Luftspalt 46, durch den der Transportpfad des Banknotenprüflings 10 verläuft.

Das Sensorelement 30 enthält darüber hinaus eine Modulationsspule 36, die wegen der verglichen mit der Rampenfrequenz relativ hohen Modulationsfrequenz $f_{mod}$ nahe am Luftspalt, oder, wie in Fig. 2, sogar im Luftspalt 46 angeordnet ist.

Die Rampspule 42 dient neben der Erzeugung der Rampenfunktion des Polarisationsfelds auch der Kompensation eventueller Drifts der Stärke des Polarisationsfelds. Aufgrund der vergleichsweise langsamen Zeitskala werden die durch die Rampspule 42 erzeugten Feldänderungen gut durch den Magnetkern 44 geleitet, so dass die Rampspule 42 vorzugsweise um den Magnetkern 44 gewickelt ist, wie in Fig. 2 gezeigt, so dass der knappe Bauraum im Luftspalt 46 für andere Bauteile zur Verfügung steht.

Das im Luftspalt 46 vorliegende Polarisationsfeld weist einen statischen und einen zeitveränderlichen Anteil auf, wobei der statische Anteil im Ausführungsbeispiel durch den Permanentmagneten 40 und der zeitveränderliche Anteil durch die Rampspule 42 und die Modulationsspule 36 erzeugt werden. Die Rampspule 42 erzeugt die langsamen Feldänderungen (Rampenfunktion und Driftkompensation mit $f_{sweep}$ < 1 kHz), die Modulationsspule 36 die schnellen Feldänderungen mit $f_{mod}$ = 1 kHz ... 1 MHz. Im Ausführungsbeispiel wird der statische Anteil des Polarisationsfelds mittels eines Permanentmagneten 40 erzeugt, wodurch gegenüber einem Aufbau, bei dem auch der statische Anteil durch einen Elektromagneten erzeugt wird, der Energieverbrauch und die Abwärme reduziert werden.

Grundsätzlich können die Modulationsspule 36 und die Rampspule 42 entlang des magnetischen Kreises jeweils im Luftspalt 46 vorliegen, um den Magnetkern 44 gewickelt sein oder um den Permanentmagneten 40 gewickelt sein. Modulationsspule und Rampspule können dabei auch durch eine einzige, gemeinsame Spule gebildet sein. Bei der vorteilhaften Ausgestaltung der Fig. 2 sind separate Spulen für die Modulation und die Rampenfunktion vorgesehen, wobei die Modulationsspule 36 im Luftspalt 46 angeordnet ist und die Rampspule 42 um den Magnetkern 44 gewickelt ist. Dadurch sind die Signalquellen für das Modulations- und für das Rampensignal elektrisch besser voneinander getrennt, was einen einfacheren Aufbau der Elektronik ermöglicht.

Als Besonderheit ist der Magnetkern 44 des Sensorelements 30 zumindest teilweise aus einem wirbelstromdämpfenden Magnetmaterial gebildet, also aus einem Material, das bei hoher Permeabilität und hoher Sättigungsflussdichte dennoch eine niedrige elektrische Leitfähigkeit aufweist.

Durch diese Ausbildung erfüllt der Magnetkern 44 gleichzeitig mehrere Anforderungen. Er weist einerseits eine hohe Permeabilität $\mu$ auf, und kann daher den magnetischen Fluss des Permanentmagneten 40 und der um den Kern bzw. den Permanentmagneten gewickelten Spulen 42 gut bündeln und weitgehend verlustfrei zum Luftspalt 46 leiten. Auch wird der unerwünschte magnetische Streufluss außerhalb des Luftspalts und quer zu den Jochen des Magnetkerns stark unterdrückt. Der Magnetkern 44 weist weiter eine hohe Sättigungsflussdichte $B_S$ auf und kann dadurch im Luftspalt 46 ein hohes Magnetfeld erzeugen und ermöglicht zudem eine kompakte Bauform des Sensorelements 30.

Darüber hinaus weist der Magnetkern 44 zumindest in kritischen Teilbereichen eine niedrige elektrische Leitfähigkeit und damit wirbelstromdämpfende Eigenschaften auf. Die Erfinder haben erkannt, dass dadurch mehrere Vorteile gegenüber Magnetkernen aus Vollmaterial realisiert werden können.

Bei Magnetkernen aus einem Vollmaterial hoher Permeabilität $\mu$ und hoher Sättigungsflussdichte $B_S$, wie etwa Weicheisen, werden nämlich wegen der hohen Leitfähigkeit des Weicheisens von den zeitlich veränderlichen Magnetfeldern Wirbelströme im Magnetkern induziert. Die Stärke dieser Wirbelströme steigt dabei mit der Leitfähigkeit des Vollmaterials und mit der Modulationsfrequenz an. Diese Wirbelströme haben mehrere nachteilige und unerwünschte Folgen:

Zum einen hat das durch Wirbelströme erzeugte Magnetfeld nach der Lenzschen Regel eine seiner Ursache entgegengesetzte Polarität, die Wirbelströme schwächen also das Modulationsfeld, das Rampfeld oder auch ein gepulstes Hochfrequenzfeld ab. Da das Nutzsignal einer Spinresonanz-Messung direkt proportional zur Stärke des Modulationsfelds ist, führen die Wirbelströme zu einem Signalverlust.

Weiter erfordert der Sensorbetrieb insbesondere bei schnell laufenden Banknoten-Bearbeitungsmaschinen kurze Messzeiten und damit auch hohe Modulationsfrequenzen. Da die Stärke der Wirbelströme mit der Modulationsfrequenz zunimmt, wird ein Sensorbetrieb auf schnellen Maschinen erschwert oder unmöglich gemacht.

Die mit den Wirbelströmen verbundene Energiedissipation im Magnetkern führt zudem zu einer Temperaturerhöhung des Kerns und damit zu einem sich verändernden magnetischen Widerstand, der seinerseits zu einem Drift der Flussdichte im Luftspalt und damit letztlich zu einem unerwünschten Drift des Nutzsignals führt. Schließlich haben die Erfinder auch festgestellt, dass Wirbelströme bei einer gepulsten Hochfrequenz-Anregung zu Artefakten im Messsignal führen, und dass sie magnetische Inhomogenitäten erzeugen und dadurch zu einer Verbreiterung der spektralen Linien der Hochfrequenz-Resonanz führen.

All diese Nachteile können durch die erfindungsgemäße Ausgestaltung des Magnetkerns stark vermindert oder ganz vermieden werden. Dies erlaubt den Einsatz hoher Modulationsfrequenzen und macht dadurch Messungen an schnell bewegten Banknoten möglich. Starke Modulationsfelder führen dabei auch zu einem besseren Signal-zu-Rausch-Verhältnis und damit zu genaueren Messergebnissen. Die verringerte Energiedissipation im magnetischen Kreis bewirkt zudem eine Stabilisierung des Polarisationsfelds und erlaubt dadurch reproduzierbarere Messungen. Schließlich ermöglicht ein wirbelstromdämpfender Magnetkern auch eine größere Freiheit der Anordnung der Bauteile. Beispielsweise kann die Modulationsspule wegen der geringeren Verluste dann um den wirbelstromdämpfenden Magnetkern gewickelt werden und dadurch knappen Bauraum am oder im Luftspalt frei geben. Bei Magnetkernen aus Vollmaterial ist eine direkte Einkopplung des hochfrequenten Modulationsfeldes in den Magnetkern wegen der großen induzierten Wirbelströme dagegen nicht sinnvoll.

Als gut geeignete wirbelstromdämpfende Magnetmaterialien haben sich Blech-/ Lamellenpakete aus weichmagnetischen Werkstoffen, Ferrite und Pulvermaterialien aus weichmagnetischen Materialien herausgestellt, wie weiter oben bereits genauer erläutert.

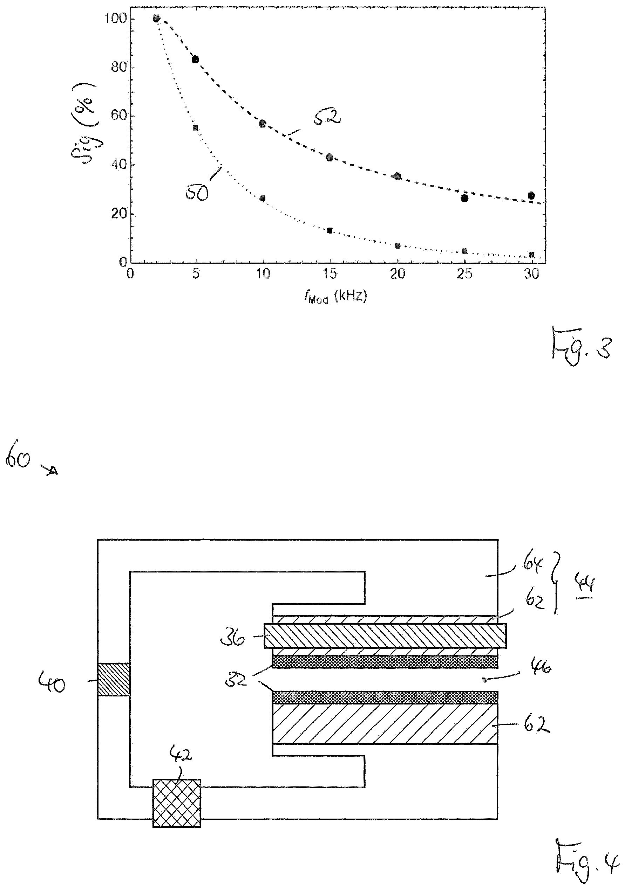

Figur 3 illustriert die vorteilhaften Eigenschaften eines Magnetkerns mit wirbelstromdämpfenden Elementen in einem Sensorelement 30. Als Ausgangspunkt dient ein Sensorelement mit einem aus Weicheisen gefertigten Magnetkern mit einem NdFeB-Permanentmagneten, einer Rampspule abseits des Luftspalts und einer Modulationsspule in der Nähe des Luftspalts. Der Luftspalt im Weicheisen-Kern hat dabei eine Höhe von 10 mm und einen quadratischen Querschnitt mit 30 mm Kantenlänge.

Um einen Luftspalt einer Höhe von nur 5 mm zu schaffen, wird je ein Flussleitstück mit Abmessungen von 30 x 30 x 5 $mm^3$ in den Luftspalt des Weicheisen-Kerns eingelegt. Das Flussleitstück besteht in einer ersten Variante aus einem Ferriten auf NiZn-Basis und in einer zweiten Variante aus einem Pulver-Material auf SiFe-Basis. Durch Einlegen dieser Flussleitstücke wird ein Magnetkern geschaffen, der nahe des Spaltes, wo das magnetische Wechselfeld und damit die induzierten Wirbelströme am stärksten sind, aus einem wirbelstromdämpfenden Material besteht.

Bei einem Vergleichsbeispiel wurde ein Flussleitstück aus Weicheisen verwendet, so dass der Vergleichskern keinen Bereich mit wirbelstromdämpfendem Material aufweist.

In dem jeweils entstehenden 5 mm hohen Luftspalt der Magnetkerne wurde dann das Antwortsignal einer mit einem Spinresonanz-Merkmal beladenen Probe im Zentrum des Luftspalts als Funktion der Modulationsfrequenz untersucht, wobei Modulationsfrequenzen $f_{mod}$ zwischen 2 und 30 kHz verwendet wurden. Das Integral der Resonanzkurve stellt die RF-Absorption in Abhängigkeit von der Magnetfeldstärke dar. Dabei wurde als Maß für die Signalintensität jeweils die Fläche unter der Absorptionskurve bestimmt, und die Signalintensitäten für den Vergleich bei der Modulationsfrequenz $f_0$ = 2 kHz auf 100% normiert.

Die erhaltenen Ergebnisse sind in Fig. 3 dargestellt, wobei die relative Signalintensität in Prozent bezogen auf die Signalstärke bei $f_0$ = 2 kHz in Abhängigkeit von der Modulationsfrequenz gezeigt ist. Wie aus der Figur ersichtlich, ergibt sich für das Vergleichsbeispiel (Weicheisen, Kurve 50) ein mit der Modulationsfrequenz wesentlich schneller abfallendes Nutzsignal als bei der Verwendung von Flussleitstücken aus Ferriten (Kurve 52).

Ohne auf eine bestimmte Erklärung festgelegt sein zu wollen, wird dieser raschere Signalabfall auf Verluste durch Wirbelströme zurückgeführt, die durch die Feldmodulation im Weicheisen-Flussleitstück induziert werden. Diese Wirbelströme schwächen das Modulationsfeld und somit auch die Spinresonanz-Signalkurve.

Im Falle des Ferrit-Flussleitstückes ist der Signalabfall aufgrund der stark reduzierten Wirbelströme wesentlich geringer. Zur Quantifizierung wurde die $f_{50\%}$-Modulationsfrequenz bestimmt, also diejenige Frequenz, bei der die Signalstärke auf 50% des Referenzwerts abgefallen ist. Wie aus Fig. 3 ersichtlich, kann durch Verwendung eines Ferrit-Flussleitstückes eine Steigerung der $f_{50\%}$-Modulationsfrequenz um 120% gegenüber einem Weicheisen-Flussleitstück erreicht werden. Bei Verwendung eines Pulver-Flussleitstückes mit einem Pulvermaterial auf SiFe-Basis wurde bei einer analogen Messung eine Steigerung der $f_{50\%}$-Modulationsfrequenz um 50% gegenüber dem Weicheisen-Flussleitstück erhalten.

Figur 4 zeigt als weiteres Ausführungsbeispiel der Erfindung ein Sensorelement 60, das auf einfache Weise in eine Banknoten-Bearbeitungsmaschine integriert werden kann. Die zu prüfenden Banknoten werden dabei senkrecht zur Bildebene durch den Luftspalt 46 des Magnetkerns transportiert.

Der Magnetkern 44 des Sensorelements 60 zeichnet sich durch die Verwendung eines einzelnen Permanent-Magneten 40 aus, der auf der dem Luftspalt 46 gegenüberliegenden Seite im magnetischen Kreis des Magnetkerns 44 angeordnet ist. Weiterhin werden im Magnetkern 44 sowohl wirbelstromdämpfende Ferrit-Elemente 62, als auch wirbelstromdämpfende Elektroblech-Elemente 64 als magnetische Leiter verwendet.

Die beiden wirbelstromdämpfenden Ferrit-Elemente 62 sind in der Nähe des Luftspalts 46 angeordnet, wobei die Modulationsspule 36 um eines der Ferrit-Elemente 62 gewickelt ist. Die ebenfalls wirbelstromdämpfenden Elektroblech-Elemente 64 bilden den übrigen Magnetkern 44. Die Rampspule 42 ist abseits des Luftspalts 46 um den Magnetkern 44 gewickelt. Da der Magnetkern 44 im Ausführungsbeispiel ausschließlich durch wirbelstromdämpfende Elemente 62, 64 gebildet ist, erlaubt die Rampspule 42 neben einer Feld- Kompensation auch ein schnelles Rampen des Feldes im Luftspalt 46.

Als Resonator 32 kommt ein Oberflächen-Resonator zum Einsatz, der auf einfache Art und Weise in den Luftspalt 46 integriert werden kann und der für die Messung der Spinresonanz-Merkmale von Banknoten optimiert ist.

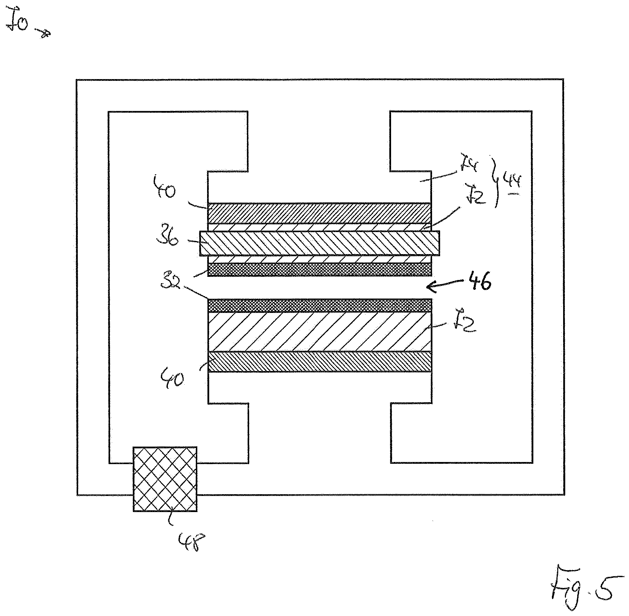

Ein Sensorelement 70 für eine Banknoten-Prüfvorrichtung nach einem weiteren Ausführungsbeispiel der Erfindung ist in Fig. 5 illustriert. Auch das Sensorelement 70 kann aufgrund seiner Auslegung in einfacher Weise in eine Banknoten-Bearbeitungsmaschine integriert werden, wobei die zu prüfenden Banknoten senkrecht zur Bildebene durch den Luftspalt 46 des Magnetkerns transportiert werden.

Der Magnetkern 44 des Sensorelements 70 enthält zwei Permanentmagneten 40, die in der Nähe des Luftspalts 46 zum Einsatz kommen. Der Magnetkern 44 enthält im Bereich zwischen den Permanentmagneten 40 und dem Luftspalt 46 jeweils wirbelstromdämpfende Pulver-Kernelemente 72, der übrige Magnetkern ist durch Weicheisen-Vollmaterial 74 gebildet. Die Modulationsspule 36 ist um eines der beiden Pulver-Kernelemente 72 gewickelt, während eine Kompensationsspule 48 abseits des Luftspalts 46 um einen Weicheisenbereich 74 des Magnetkerns gewickelt ist. Die Kompensationsspule 48 wird in diesem Ausführungsbeispiel daher nur zur langsamen Driftkompensation verwendet. Als Resonator 32 kommt wie bei dem Ausführungsbeispiel der Fig. 4 ein einfach zu integrierender Oberflächen-Resonator zum Einsatz.

Auch bei der Ausgestaltung der Fig. 5 werden die durch die Modulationsspule 36 erzeugten Wirbelströme durch die wirbelstromdämpfenden Pulver-Kernelemente 72 gegenüber einem vergleichbaren Aufbau mit einem vollständig aus Weicheisen-Vollmaterial bestehenden Magnetkern wirkungsvoll unterdrückt.

Bezugszeichenliste

| | |
|---|---|
| 10 | Banknotenprüfling |
| 12 | Spinresonanz-Merkmal |
| 14 | Transportpfad |
| 20 | Prüfvorrichtung |
| 22 | Signalquelle |
| 24 | Duplexer |
| 26 | Detektor |
| 28 | Auswerteeinheit |
| 30 | Sensorelement |
| 32 | Resonator |
| 34 | Polarisationsmagnet |
| 40 | Permanentmagnet |
| 42 | Rampspule |
| 44 | Magnetkern |
| 46 | Luftspalt |

| 48 | Kompensationsspule |
|---|---|
| 50, 52 | Kurven |
| 60 | Sensorelement |
| 62 | Ferrit-Elemente |
| 64 | Elektroblech-Elemente |
| 70 | Sensorelement |
| 72 | Pulver-Kernelemente |
| 74 | Weicheisen-Vollmaterial |

**Patentansprüche**

1. Sensorelement (30, 60, 70) für die Prüfung eines flächigen Datenträgers (10), insbesondere einer Banknote, mit einem Spinresonanz-Merkmal (12), mit

   - einem Magnetkern (44) mit einem Luftspalt (46), in den der flächige Datenträger (10) zur Echtheitsprüfung einbringbar ist,
   - einem Element (40) zu Erzeugung eines statischen magnetischen Flusses in dem Luftspalt (46),
   - einer Modulationsspule (36) zur Erzeugung eines zeitlich variierenden Magnetfelds in dem Luftspalt (46), und
   - einem Resonator (32) zur Anregung des Spinresonanz-Merkmals (12) des zu prüfenden Datenträgers (10) und zur Erfassung der Signalantwort des Spinresonanz-Merkmals (12),
   - einer Auswerteeinheit, die dazu eingerichtet ist, anhand der erfassten Signalantwort des Spinresonanz-Merkmals ein Prüfergebnis zu erzeugen,
   wobei der Magnetkern (44) zumindest teilweise aus einem wirbelstromdämpfenden Magnetmaterial (62, 64, 72) gebildet ist und als wirbelstromdämpfendes Magnetmaterial ein Pulver aus voneinander elektrisch isolierten weichmagnetischen Körnern umfasst, und
   wobei das Element (40) zur Erzeugung eines statischen magnetischen Flusses zumindest einen Permanentmagneten umfasst.

2. Sensorelement (30, 60, 70) nach Anspruch 1, **dadurch gekennzeichnet, dass** der Magnetkern (44) als wirbelstromdämpfendes Magnetmaterial ein Lamellenpaket aus einem weichmagnetischen Werkstoff, insbesondere auf Basis einer SiFe-Legierung, einer NiFe-Legierung, einer CoFe-Legierung, einer AlFe-Legierung oder eines metallischen Glases umfasst.

3. Sensorelement (30, 60, 70) nach Anspruch 1 oder 2, **dadurch gekennzeichnet, dass** der Magnetkern (44) als wirbelstromdämpfendes Magnetmaterial ein Ferrit (62), insbesondere auf Basis von MnZn oder NiZn umfasst.

4. Sensorelement (30, 60, 70) nach wenigstens einem der Ansprüche 1 bis 3, **dadurch gekennzeichnet, dass** der Magnetkern (44) neben dem zumindest einen wirbelstromdämpfenden Magnetmaterial ein Vollmaterial hoher Permeabilität und hoher Sättigungsflussdichte, insbesondere Weicheisen, umfasst.

5. Sensorelement (30, 60, 70) nach wenigstens einem der Ansprüche 1 bis 4, **dadurch gekennzeichnet, dass** der Magnetkern (44) zumindest in einem, bevorzugt in beiden, an den Luftspalt (46) angrenzenden Bereichen durch ein wirbelstromdämpfendes Magnetmaterial gebildet ist.

6. Sensorelement (30, 60, 70) nach wenigstens einem der Ansprüche 1 bis 5, **dadurch gekennzeichnet, dass** die Modulationsspule (36) im Luftspalt (46) des Magnetkerns (44) angeordnet ist.

7. Sensorelement (30, 60, 70) nach wenigstens einem der Ansprüche 1 bis 5, **dadurch gekennzeichnet, dass** die Modulationsspule (36) um einen Bereich des Magnetkerns (44) mit wirbelstromdämpfendem Magnetmaterial, insbesondere um einen Bereich mit dem genannten Ferrit-Magnetmaterial oder Pulver-Magnetmaterial, gewickelt ist.

8. Sensorelement (30, 60, 70) nach wenigstens einem der Ansprüche 1 bis 7, **dadurch gekennzeichnet, dass** der Resonator (32) im Luftspalt (46) des Magnetkerns (44) angeordnet ist.

9. Sensorelement (30, 60, 70) nach wenigstens einem der Ansprüche 1 bis 8, **dadurch gekennzeichnet, dass** das Sensorelement (30, 60, 70) eine Rampspule (42) zur Erzeugung eines gegenüber dem Modulationsfeld langsam zeitlich variierenden Magnetfelds in dem Luftspalt (46) aufweist, die vorzugsweise um den Magnetkern (44), insbesondere einen wirbelstromdämpfenden Bereich des Magnetkerns (44), gewickelt ist.

10. Sensorelement (30, 60, 70) nach wenigstens einem der Ansprüche 1 bis 9, **dadurch gekennzeichnet, dass** die Modulationsspule (36) auf die Erzeugung eines mit einer Frequenz zwischen etwa 1 kHz und etwa 1 MHz variierenden Magnetfelds in dem Luftspalt (46) ausgelegt ist, und/oder, dass die Rampspule auf die Erzeugung eines mit einer Frequenz unterhalb von etwa 1 kHz variierenden Magnetfelds in dem Luftspalt (46) ausgelegt ist, und/oder dass der Resonator (32) auf die Anregung und Erfassung von Spinresonanz-Signalen mit einer Frequenz zwischen etwa 1 MHz und 100 GHz ausgelegt ist.

11. Prüfvorrichtung (20) für die Echtheitsprüfung flächiger Datenträger, insbesondere Banknoten, mit einem Sensorelement (30) nach einem der Ansprüche 1 bis 10 und mit einer Transporteinrichtung, die die zu prüfenden flächigen Datenträger (10) entlang eines Transportpfades in den Luftspalt (46) des Magnetkerns (44) einbringt bzw. durch den Luftspalt (46) des Magnetkerns (44) hindurchführt.

12. Verwendung eines Sensorelements nach einem der Ansprüche 1 bis 10 zur Echtheitsprüfung eines flächigen Datenträgers (10) mit Spinresonanz-Merkmal (12).

## Claims

1. Sensor element (30, 60, 70) for checking a planar data carrier (10), in particular a banknote, comprising a spin resonance feature (12), comprising

   - a magnetic core (44) with an air gap (46), into which the planar data carrier (10) is introducible for the purpose of checking authenticity,
   - an element (40) for generating a static magnetic flux in the air gap (46),
   - a modulation coil (36) for generating a time-varying magnetic field in the air gap (46), and
   - a resonator (32) for exciting the spin resonance feature (12) of the data carrier (10) to be checked and for capturing the signal response of the spin resonance feature (12),
   - an evaluation unit configured to generate a checking result on the basis of the captured signal response of the spin resonance feature,
   wherein the magnetic core (44) is at least partly formed from an eddy-current-damping magnetic material (62, 64, 72) and comprises, as eddy-current-damping magnetic material, a powder composed of soft-magnetic grains electrically insulated from one another, and
   wherein the element (40) for generating a static magnetic flux comprises at least one permanent magnet.

2. Sensor element (30, 60, 70) according to Claim 1, **characterized in that** the magnetic core (44) comprises, as eddy-current-damping magnetic material, a lamination stack composed of a soft-magnetic material, in particular based on an SiFe alloy, an NiFe alloy, a CoFe alloy, an AlFe alloy or a metallic glass.

3. Sensor element (30, 60, 70) according to Claim 1 or 2, **characterized in that** the magnetic core (44) comprises, as eddy-current-damping magnetic material, a ferrite (62), in particular based on MnZn or NiZn.

4. Sensor element (30, 60, 70) according to at least one of Claims 1 to 3, **characterized in that** the magnetic core (44) comprises, besides the at least one eddy-current-damping magnetic material, a solid material of high permeability and high saturation flux density, in particular soft iron.

5. Sensor element (30, 60, 70) according to at least one of Claims 1 to 4, **characterized in that** the magnetic core (44) is formed by an eddy-current-damping magnetic material at least in one region, preferably in both regions, adjoining the air gap (46).

6. Sensor element (30, 60, 70) according to at least one of Claims 1 to 5, **characterized in that** the modulation coil (36) is arranged in the air gap (46) of the magnetic core (44).

7. Sensor element (30, 60, 70) according to at least one of Claims 1 to 5, **characterized in that** the modulation coil (36) is wound around a region of the magnetic core (44) with eddy-current-damping magnetic material, in particular around a region with the aforementioned ferrite magnetic material or powder magnetic material.

8. Sensor element (30, 60, 70) according to at least one of Claims 1 to 7, **characterized in that** the resonator (32) is arranged in the air gap (46) of the magnetic core (44).

9. Sensor element (30, 60, 70) according to at least one of Claims 1 to 8, **characterized in that** the sensor element (30, 60, 70) has a ramp coil (42) for generating a magnetic field in the air gap (46) which varies slowly over time with respect to the modulation field, which ramp coil is preferably wound around the magnetic core (44), in particular an eddy-current-damping region of the magnetic core (44).

10. Sensor element (30, 60, 70) according to at least one of Claims 1 to 9, **characterized in that** the modulation coil (36) is designed to generate a magnetic field in the air gap (46) which varies with a frequency of between approximately 1 kHz and approximately 1 MHz, and/or **in that** the ramp coil is designed to generate a magnetic field in the air gap (46) which varies with a frequency of below approximately 1 kHz, and/or **in that** the resonator (32) is designed to excite and capture spin resonance signals with a frequency of between approximately 1 MHz and 100 GHz.

11. Checking apparatus (20) for checking the authenticity of planar data carriers, in particular banknotes, comprising a sensor element (30) according to any of Claims 1 to 10 and comprising a transport device, which introduces the planar data carriers (10) to be checked along a transport path into the air gap (46) of the magnetic core (44) or guides them through the air gap (46) of the magnetic core (44).

12. Use of a sensor element according to any of Claims 1 to 10 for checking the authenticity of a planar data carrier (10) comprising a spin resonance feature (12).

**Revendications**

1. Élément capteur (30, 60, 70) destiné à tester un support de données (10) sensiblement bidimensionnel, en particulier un billet de banque, pourvu d'une caractéristique de résonance de spin (12), ledit élément capteur comprenant

- un noyau magnétique (44) pourvu d'un entrefer (46) dans lequel le support de données (10) sensiblement bidimensionnel peut être inséré afin d'effectuer d'un test d'authenticité,
- un élément (40) destiné à générer un flux magnétique statique dans l'entrefer (46),
- une bobine de modulation (36) destinée à générer un champ magnétique variable dans le temps dans l'entrefer (46), et
- un résonateur (32) destiné à exciter la caractéristique de résonance de spin (12) du support de données (10) à tester et détecter la réponse de signal de la caractéristique de résonance de spin (12),
- une unité d'évaluation qui est conçue pour générer un résultat de test sur la base de la réponse de signal détectée de la caractéristique de résonance de spin,
le noyau magnétique (44) étant au moins partiellement formé à partir d'un matériau magnétique qui amortit les courants de Foucault (62, 64, 72) et comprenant, comme matériau magnétique qui amortit les courants de Foucault, une poudre de grains magnétiques doux qui sont électriquement isolés les uns des autres, et l'élément (40) destiné à générer un flux magnétique statique comprenant au moins un aimant permanent.

2. Élément capteur (30, 60, 70) selon la revendication 1, **caractérisé en ce que** le noyau magnétique (44) comprend, comme matériau magnétique qui amortit les courants de Foucault, un paquet de lamelles en un matériau magnétique doux, notamment à base d'un alliage SiFe, d'un alliage NiFe, d'un alliage CoFe, d'un alliage AlFe ou d'un verre métallique.

3. Élément capteur (30, 60, 70) selon la revendication 1 ou 2, **caractérisé en ce que** le noyau magnétique (44) comprend, comme matériau magnétique qui amortit les courants de Foucault, une ferrite (62), notamment à base de MnZn ou NiZn.

4. Élément capteur (30, 60, 70) selon l'une au moins des revendications 1 à 3, **caractérisé en ce que** le noyau magnétique (44) comprend, en plus de l'au moins un matériau magnétique qui amortit les courants de Foucault, un matériau solide à haute perméabilité et à haute densité de flux de saturation, en particulier le fer doux.

5. Élément capteur (30, 60, 70) selon l'une au moins des revendications 1 à 4, **caractérisé en ce que** le noyau magnétique (44) est formé par un matériau magnétique qui amortit les courants de Foucault au moins dans l'une des zones adjacentes à l'entrefer (46), de préférence dans les deux.

6. Élément capteur (30, 60, 70) selon l'une au moins des revendications 1 à 5, **caractérisé en ce que** la bobine de modulation (36) est disposée dans l'entrefer (46) du noyau magnétique (44).

7. Élément capteur (30, 60, 70) selon l'une au moins des revendications 1 à 5, **caractérisé en ce que** la bobine de modulation (36) est entourée autour d'une zone du noyau magnétique (44) comportant un matériau magnétique qui amortit les courants de Foucault, en particulier autour d'une zone comportant ledit matériau magnétique à ferrite ou ledit matériau magnétique à poudre.

8. Élément capteur (30, 60, 70) selon l'une au moins des revendications 1 à 7, **caractérisé en ce que** le résonateur (32) est disposé dans l'entrefer (46) du noyau magnétique (44).

9. Élément capteur (30, 60, 70) selon l'une au moins des revendications 1 à 8, **caractérisé en ce que** l'élément capteur (30, 60, 70) comporte dans l'entrefer une bobine à rampe (42) qui est destinée à générer un champ magnétique qui varie lentement dans le temps par rapport au champ de modulation (46) et qui est de préférence enroulé autour du noyau magnétique (44), notamment d'une zone du noyau magnétique (44) qui amortit les courants de Foucault.

10. Élément capteur (30, 60, 70) selon l'une au moins des revendications 1 à 9, **caractérisé en ce que** la bobine de modulation (36) est conçue pour générer dans l'entrefer (46) un champ magnétique variant avec une fréquence comprise entre environ 1 kHz et environ 1 MHz, et/ou **en ce que** la bobine à rampe est conçue pour générer dans l'entrefer (46) un champ magnétique qui varie avec une fréquence inférieure à environ 1 kHz, et/ou **en ce que** le résonateur (32) est conçu pour exciter et détecter des signaux de résonance de spin à une fréquence comprise entre environ 1 MHz et 100 GHz.

11. Dispositif de test (20) destiné à effectuer un test d'authenticité de supports de données sensiblement bidimensionnels, en particulier de billets de banque, ledit dispositif comprenant un élément capteur (30) selon l'une des revendications 1 à 10 et un module de transport qui achemine les supports de données (10) sensiblement bidimensionnels à tester le long d'un chemin de transport jusque dans l'entrefer (46) du noyau magnétique (44) ou à travers l'entrefer (46) du noyau magnétique (44).

12. Utilisation d'un élément capteur selon l'une des revendications 1 à 10 pour effectuer un test d'authenticité sur un support de données plat (10) présentant une caractéristique de résonance de spin (12).

Fig. 1

Fig. 2

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5149946 A
- SU 1054752 A1